# EUROPEAN PATENT APPLICATION

(11) **EP 4 779 344 A1**
(43) Date of publication of application: **22.07.2026**
(21) Application number: 25153168.7
(22) Date of filing: 21.01.2025
(51) Int. Cl.: G01R 33/38

(54) **MAGNET AND MAGNETIC RESONANCE IMAGING SYSTEM WITH THERMAL SWITCH FOR COOLING PERSISTENT CURRENT SWITCH**

(71) Applicant: Koninklijke Philips N.V., 5656 AE Eindhoven (NL)
(72) Inventor: BROOMFIELD, Dylan, Eindhoven (NL)
(74) Representative: Philips Intellectual Property & Standards

(57) **Abstract**

A superconducting magnet includes a vacuum vessel containing superconducting magnet windings and a persistent current switch (PCS) operative to switch the magnet between a persist mode and a ramp mode. A cryogenic cold head has a cold station thermally connected with the superconducting magnet windings to cool the superconducting magnet windings. A thermosiphon thermally connects the cold station of the cryogenic cold head with the PCS. A pneumatic valve has an expansion chamber, and is configured to block flow of working fluid through the thermosiphon when the expansion chamber is above a threshold temperature and to pass flow of the working fluid through the thermosiphon when the expansion chamber is below the threshold temperature. The thermosiphon has a liquid drop, and a heater is arranged to heat the liquid drop to boil working fluid contained in the liquid drop to accelerate startup of the thermosiphon.

## Description

### FIELD OF THE INVENTION

The following relates generally to the magnetic resonance imaging arts, magnet arts, and related arts.

### BACKGROUND OF THE INVENTION

Superconducting magnets use a persistent current switch (PCS) made of superconducting wire to switch the superconducting magnet between a current ramping mode and persist mode. When the superconducting wire of the PCS is heated above the critical temperature of the superconducting wire, it is no longer superconducting. A heater of the PCS enables the PCS to be opened by heating the superconducting wire above its critical temperature for superconductivity. The heated superconducting wire is highly resistive (as compared with the superconductor of the superconducting magnet windings), thus changing the impedance of that part of the magnet circuit and redistributing the electrical current. The PCS is switched to be open (not superconducting) when ramping the magnet current, discharging, or quenching the magnet. During normal operation in persist mode, the PCS is closed (i.e., superconducting) so that the superconducting current can circulate through the magnet windings and the superconducting PCS wire.

Opening the PCS by heating the superconducting wire of the PCS above its critical temperature imposes a thermal load on the magnet. This thermal load can reduce magnet efficiency and increase likelihood of a thermal quench, which can damage the superconducting magnet windings. The potential adverse impact of this thermal load is increased if the magnet is designed to employ a low volume of liquid helium, or no liquid helium, as in the case of some sealed superconducting magnet designs.

The following discloses certain improvements to overcome these problems and others.

### SUMMARY OF THE INVENTION

In some nonlimiting illustrative embodiments, a superconducting magnet for a magnetic resonance imaging (MRI) device includes: a vacuum vessel; superconducting magnet windings disposed in the vacuum vessel; a persistent current switch (PCS) comprising a superconductor connecting with the superconducting magnet windings and a heater, the PCS operative to switch between a persist mode in which the heater is off and a ramp mode in which the heater is on; a cryogenic cold head having a cold station thermally connected with the superconducting magnet windings to cool the superconducting magnet windings; a thermosiphon thermally connecting the cold station of the cryogenic cold head with the PCS, the thermosiphon containing a working fluid; and a pneumatic valve having an expansion chamber, the pneumatic valve configured to block flow of the working fluid through the thermosiphon when the expansion chamber is above a threshold temperature and to pass flow of the working fluid through the thermosiphon when the expansion chamber is below the threshold temperature.

In some nonlimiting illustrative embodiments, a superconducting magnet for an MRI device includes: a vacuum vessel; superconducting magnet windings disposed in the vacuum vessel; a persistent current switch (PCS) comprising a superconductor connecting with the superconducting magnet windings and a heater, the PCS operative to switch between a persist mode in which the heater is off and a ramp mode in which the heater is on; a cryogenic cold head having a cold station thermally connected with the superconducting magnet windings to cool the superconducting magnet windings; and a thermosiphon thermally connecting the cold station of the cryogenic cold head with the PCS, the thermosiphon containing a working fluid. The thermosiphon includes a liquid drop.

In some nonlimiting illustrative embodiments, a method is disclosed of ramping current in a superconducting magnet comprising a vacuum vessel with a thermal shield disposed in the vacuum vessel and superconducting magnet windings disposed inside the thermal shield. A persistent current switch (PCS) is operatively connected with the superconducting magnet windings, and a cryogenic cold head has a first stage cold station thermally connected with the thermal shield and a second stage cold station thermally connected with the superconducting magnet windings. The method includes: using the cryogenic cold head, cooling the superconducting magnet windings to a superconducting temperature; heating the PCS with a heater of the PCS to open the PCS; with the PCS open due to the heating, ramping a superconducting current in the superconducting magnet windings; after the ramping, turning off the heating of the PCS whereby the PCS begins to cool; and at a threshold temperature, starting operation of a thermosiphon thermally connecting the PCS with the second stage cold station of the cryogenic cold head using a pneumatic valve.

In some nonlimiting illustrative embodiments, a superconducting magnet includes a vacuum vessel containing superconducting magnet windings and a persistent current switch (PCS) operative to switch the magnet between a persist mode and a ramp mode. A cryogenic cold head has a cold station thermally connected with the superconducting magnet windings to cool the superconducting magnet windings. A thermosiphon thermally connects the cold station of the cryogenic cold head with the PCS. A pneumatic valve has an expansion chamber, and is configured to block flow of working fluid through the thermosiphon when the expansion chamber is above a threshold temperature and to pass flow of the working fluid through the thermosiphon when the expansion chamber is below the threshold temperature. The thermosiphon has a liquid drop, and a heater is arranged to heat the liquid drop to boil working fluid contained in the liquid drop to accelerate startup of the thermosiphon.

One advantage resides in providing a superconducting magnet with passive cooling of a persistent current switch (PCS) using a thermosiphon whose natural convection is passively turned on at a desired threshold temperature for doing so.

Another advantage resides in providing a superconducting magnet with passive cooling of a PCS using a thermosiphon with a liquid drop and associated heater for accelerating startup of natural convection in the thermosiphon.

Another advantage resides in providing rapid cooling of a PCS using thermosiphons with passive valving to ensure the thermosiphons do not present a risk of inducing a magnet quench.

A given embodiment may provide none, one, two, more, or all of the foregoing advantages, and/or may provide other advantages as will become apparent to one of ordinary skill in the art upon reading and understanding the present disclosure.

### BRIEF DESCRIPTION OF THE DRAWINGS

The example embodiments are best understood from the following detailed description when read with the accompanying drawing figures. It is emphasized that the various features are not necessarily drawn to scale. In fact, the dimensions may be arbitrarily increased or decreased for clarity of discussion. Wherever applicable and practical, like reference numerals refer to like elements.
Fig. 1 diagrammatically illustrates a sectional view of a magnetic resonance imaging (MRI) device including a superconducting magnet cooled by a cryogenic cold head.
Fig. 2 diagrammatically illustrates a first stage thermosiphon connecting a persistent current switch (PCS) and a first stage cold station of the cryogenic cold head.
Fig. 3 diagrammatically illustrates a second stage thermosiphon connecting a PCS and a second stage cold station of the cryogenic cold head according to an embodiment in which the second stage thermosiphon includes a pneumatic valve.
Fig. 4 diagrammatically illustrates a sectional view of the pneumatic valve of the second stage thermosiphon of FIGURE 3 according to an embodiment.
Fig. 5 diagrammatically illustrates a second stage thermosiphon connecting a PCS and a second stage cold station of the cryogenic cold head according to an embodiment in which the second stage thermosiphon includes a liquid drop.
Fig. 6 diagrammatically illustrates a sectional view of the liquid drop of the second stage thermosiphon of Fig. 5 according to an embodiment.
Fig. 7 diagrammatically illustrates a magnet startup sequence.

### DETAILED DESCRIPTION OF EMBODIMENTS

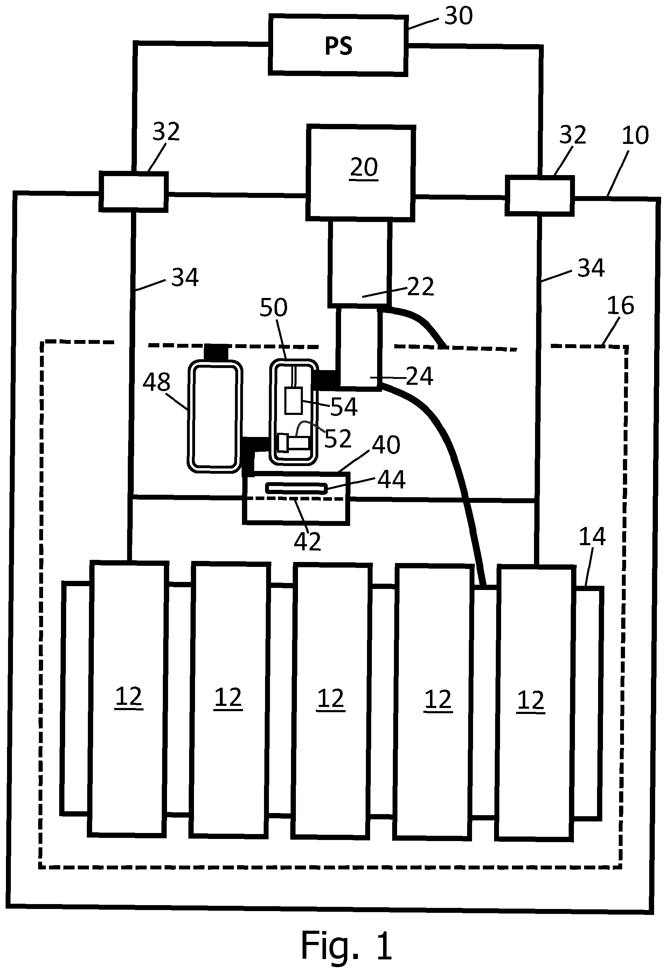

With reference to Fig. 1, a superconducting magnet for a magnetic resonance imaging (MRI) device (also referred to herein as a superconducting MRI magnet or, for brevity, as an MRI magnet) includes a vacuum vessel 10 within which is disposed superconducting magnet windings 12 mounted on a support structure 14 held in fixed position inside the vacuum vessel 10 by suitable supports (not shown). The magnet windings 12 comprise superconducting material, and may for example be arranged as a set of double-pancake coils of electrically connected in series (connections not shown). The support structure is suitably stainless steel or another suitable structural material. A thermal shield 16 of copper, copper alloy, stainless steel, or another thermally conductive material is also disposed inside the vacuum vessel, and the magnet windings 12 are disposed inside of the thermal shield 16. A cryogenic cold head 20 (also sometimes referred to as a cryocooler or similar nomenclature) employs helium (He) as a working fluid, and has a first stage cold station 22 and a second stage cold station 24. The cryogenic cold head 20 is designed to cool the first stage cold station 22 to a first temperature T1, and is designed to cool the second stage cold station 24 to a lower second temperature T2. In some nonlimiting illustrative embodiments, T1 may be around 40-50K and T2 may be about 4K. A first thermally conductive strap 26 made of copper, copper alloy, or another thermally conductive material thermally connects the first stage cold station 22 to the thermal shield 16, and a second thermally conductive strap 28 made of copper, copper alloy, or another thermally conductive material thermally connects the second stage cold station 24 to the superconducting magnet windings 12 (e.g., in some designs this thermal connection may be via the thermally conductive support structure 14). In some embodiments, the superconducting magnet is configured to operate with no liquid helium charge inside the vacuum vessel 10, or with a liquid helium charge of less than or equal to 10 liters inside the vacuum vessel 10. The helium in such a magnet may be hermetically sealed in a cooling loop connecting the coils to the second stage cold station 24 (details not shown), and thus may also be referred to as a sealed magnet.

To start up the magnet, the cryogenic cold head 20 is operated to cool the temperature of the thermal shield 16 to about the temperature T1 of the first stage cold station 22, and to cool the temperature of the superconducting magnet windings 12 to about the temperature T2 of the second stage cold station. The temperature T2 is designed to be lower than the critical temperature for the superconducting material of the superconducting magnet windings 12 to be in the superconducting state. After cooldown, an electric power supply 30 flows electric current through vacuum feedthroughs 32 and into the superconducting magnet windings 12. Although not shown in Fig. 1, it will be appreciated that electric conductors 34 carrying the current between the vacuum feedthroughs 32 and the superconducting magnet windings 12 comprise copper or another electrically conductive material proximate to the vacuum feedthroughs 32, and comprise superconducting leads proximate to the superconducting magnet windings 12.

The superconducting magnet also includes a persistent current switch (PCS) 40 comprising a superconductor 42 connecting with the superconducting magnet windings 12 and a heater 44 (e.g., a resistive heater) arranged to heat the superconductor 42, The PCS 40 is operative to switch between a persist mode in which the heater 44 is off and a ramp mode in which the heater 44 is on. During the ramp, the heater is on and heats the superconductor 42 above its superconducting transition temperature - hence, the superconductor 42 presents a relatively high resistance between the leads 34 of the superconducting magnet windings 12. Once the ramp is complete, the heater 44 is turned off and the PCS 40 begins to cool down. When the PCS 40 (and more particularly the superconductor 42 thereof) cools below the superconducting transition temperature of the superconductor 42, the PCS 40 becomes superconducting and provides a superconducting (i.e., zero resistance) connection between the leads 34 of the superconducting magnet windings 12. This is referred to as the persist (or persistence) state, because the entire conducting loop comprising the superconducting magnet windings 12 and the superconductor 42 of the PCS 40 form a zero resistance loop within which the superconducting current can flow indefinitely (or nearly indefinitely, if there is some nonzero resistance at joints between superconducting sections of the loop).

In superconducting MRI magnets that are completely or partially submerged in a bath of liquid helium, the PCS is also submerged in liquid helium. Therefore, in such submerged MRI magnets the PCS cools quickly after the heater is turned off. During the current ramp, the voltage across the open PCS creates heat so it stays hot. This is desired because it needs to stay open. After ramping, there is no voltage so the cooling from the helium returns the PCS to superconducting temperatures. Again, this is desired because this allows the PCS to "close" (i.e., become superconducting) quickly after ramping. The cooldown of the PCS is fast when it is immersed in liquid helium, and moreover, the relatively large volume of liquid helium in a submerged MRI magnet design provide a relatively large thermal capacity which can readily accommodate the heat load imposed by the (relatively small) PCS heater.

However, the situation is different in the case of a sealed magnet or other magnet such as is diagrammatically depicted in Fig. 1. In this case, there is no helium, or a low volume of helium (e.g., 10 liters or less inside the vacuum vessel 10). In the superconducting MRI magnet of Fig. 1 the PCS 40 is not submerged in liquid helium, but rather is disposed in the vacuum of the vacuum vessel 10. This limits cooling principally to radiative heat transfer, which is undesirably slow. Moreover, the limited amount of helium (e.g., no helium, or 10 liters or less of helium) means that there is limited thermal capacity to accommodate the heat load imposed by the heater 44 of the PCS 40.

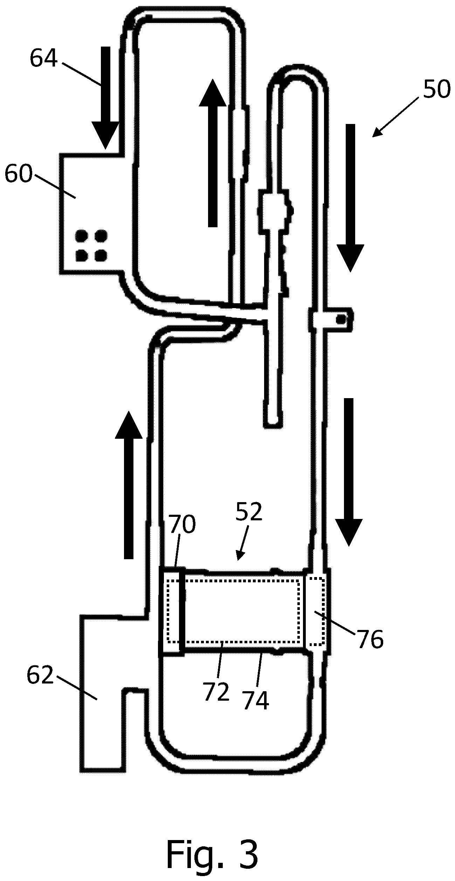

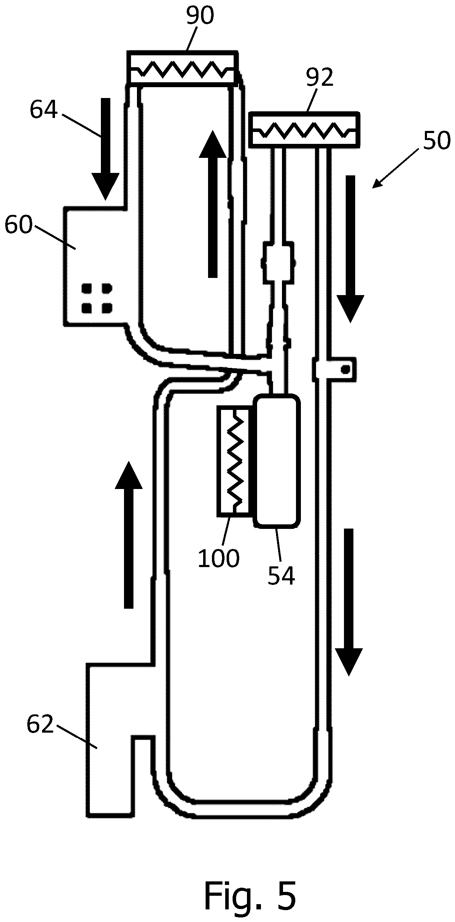

To address the above problem, one or more thermosiphons are provided to facilitate cooling of the PCS 40, especially after the heater 44 is turned off. In the illustrative example of Fig. 1, a first thermosiphon 48 thermally connects the first stage cold station 22 of the cryogenic cold head 20 with the PCS 40; and a second thermosiphon 50 thermally connects the second stage cold station 24 of the cryogenic cold head 20 with the PCS 40. More particularly, as seen in Fig. 1 an upper portion of the first thermosiphon 48 is welded or otherwise connected with the thermal shield 16 which in turn is thermally connected with the first stage cold station 22, and a lower portion of the first thermosiphon 48 is welded or otherwise connected with the PCS 40. An upper portion of the second thermosiphon 50 is welded or otherwise connected with the second stage cold station 24 and a lower portion of the second thermosiphon 50 is welded or otherwise connected to the PCS 40. Note that Fig. 1 diagrammatically shows the thermosiphons 48 and 50 as having generally rectangular shapes; however, the detailed shape of the thermosiphons can be chosen to facilitate routing, to optimize flow of the working fluid through the respective thermosiphons, and/or for other design objectives. As further diagrammatically indicated in Fig. 1, the second thermosiphon optionally includes a pneumatic valve 52, and optionally includes a liquid drop 54. The structure and operation of these components 52 and 54 will be further described later herein. While in the illustrative embodiment of Fig. 1 the second thermosiphon 50 includes both the pneumatic valve 52 and a liquid drop 54, it is contemplated in other embodiments for the second thermosiphon 50 to include only the pneumatic valve 52 (e.g., as in the example of Fig. 3); and in other embodiments for the second thermosiphon 50 to include only the liquid drop 54 (e.g., as in the example of Fig. 5).

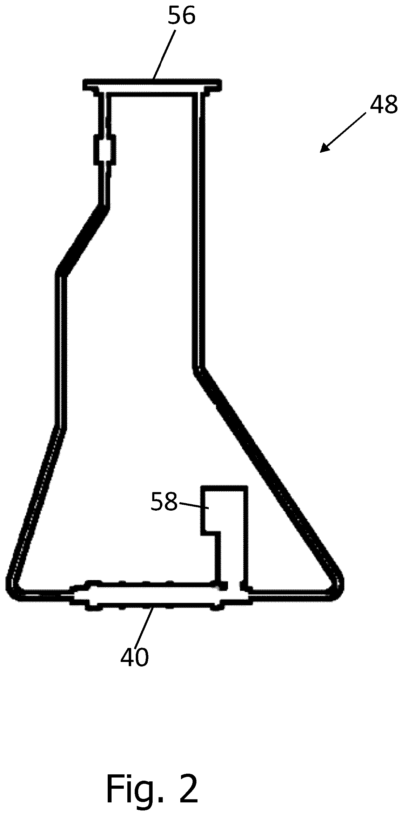

With reference to Fig. 2, a nonlimiting illustrative embodiment of the first thermosiphon 48 is shown in isolation. An upper portion 56 of the first thermosiphon 48 has a surface or other structure shaped and/or otherwise configured to be welded or otherwise thermally connected with the thermal shield 16. A lower portion of the first thermosiphon 48 is thermally connected with the PCS 40. In this nonlimiting illustrative example, a thermal connection point 58 such as a copper paddle or the like is also provided on the lower portion of the first thermosiphon 48. The thermal connection point 58 provides a thermal connection point for additionally connecting the lower portion of the second thermosiphon 50 to the PCS 40.

The first thermosiphon 48 is suitably made of stainless steel piping or tubing or the like, which contains a working fluid (e.g., helium or neon as two nonlimiting examples of possible choices for the working fluid). The first thermosiphon 48 is operational when the temperature of the PCS 40 (which at least approximately corresponds to the temperature of the lower portion of the first thermosiphon 48 connected therewith) is higher than the temperature of the upper portion 56 of the first thermosiphon 48. This temperature difference will be present immediately after the heater 44 of the PCS 40 is turned off after the magnet is ramped, because the upper portion 56 of the first thermosiphon 48 is connected to the thermal shield 16 which is at about the temperature T1 of the first stage cold station 22 (e.g., around 40K in some nonlimiting illustrative examples), while the temperature of the lower portion of the first thermosiphon 48 is at a higher temperature due to the heat that has been generated by the operating heater 44 of the PCS 40. With this temperature differential, passive heat exchange by natural convection occurs, in which the helium or other working fluid contained in the first thermosiphon 48 is heated by the residual heat from the PCS 40 and expands and rises upward to the cooler upper portion 56 of the first thermosiphon 48, where the density of the working fluid increases and therefore flows back downward. Advantageously, this natural convection passively transfers heat from the PCS 40 to the thermal shield 16 connected to the upper portion 56 of the first thermosiphon 48. The first thermosiphon 48 will continue to operate by natural convection until the temperature of the PCS 40 is cooled to about the temperature T1 of the first stage cold station 22 and connected thermal shield 16 and upper portion 56 of the first thermosiphon 48.

With returning reference to Fig. 1, the second thermosiphon 50 is also suitably made of stainless steel piping or tubing or the like, and also contains a working fluid, which is typically helium since it is designed to operate at temperatures close to the temperature T2 of the second stage cold station 24. The second thermosiphon 50 also operates by natural convection as just described for the first thermosiphon 48. The purpose of having the two thermosiphons 48 and 50 is that the first thermosiphon 48 should operate to cool the PCS 40 from its initial temperature when the heater 44 is turned off down to about the temperature T1 of the first stage cold station 22 (e.g., around 40K in some embodiments); then, the second thermosiphon 50 should operate to continue cooling the PCS 40 down to about the temperature T2 of the second stage cold station 24 (e.g., around 4K in some embodiments). While there can advantageously be some overlapping temperature range during which both thermosiphons 48 and 50 are operating simultaneously, it is not desirable for this overlap to be too large. Since the first stage cold station 22 is hotter than the second stage cold station 24, it can remove more heat. An example cryocooler 20 may remove 30W for the first stage and 1W from the second stage. In a sealed magnet with little or no helium, there is limited thermal capacity and the PCS 40 should not be thermally connected to the second stage cold station 24 (which is also thermally connected with the superconducting magnet windings 12) while the PCS 40 is at elevated temperature (e.g., when the heater 44 is operating or shortly thereafter while the PCS 40 is still relatively warm). This is because there is not enough thermal storage, and so the heat from the "warm" PCS 40 would raise the temperature of the second stage cold station 24 (and consequently of the thermally attached superconducting magnet windings 12), potentially leading to a quench the magnet.

To avoid this, the second thermosiphon 50 should be prevented from operating (i.e., performing cooling by natural convection of the helium or other working fluid contained in the second thermosiphon 50) until the PCS 40 is at a sufficiently low temperature. As described next, the pneumatic valve 52 provide this delayed operation of the second thermosiphon, and advantageously ensures that the second thermosiphon 50 does not operate prematurely.

With reference to Fig. 3, a nonlimiting illustrative embodiment of the second thermosiphon 50 is shown in isolation. An upper portion 60 of the second thermosiphon 50 has a plate, paddle, surface, or other structure shaped and/or otherwise configured to be welded or otherwise thermally connected with the second stage cold station 24. A lower portion 62 of the second thermosiphon 50 has a plate, paddle, surface, or other structure shaped and/or otherwise configured to be welded or otherwise thermally connected with the PCS 40. As a nonlimiting illustrative example, the lower portion 62 of the second thermosiphon 50 may be the same thermal connection point 58 on the lower portion of the first thermosiphon 48, or the lower portion 62 of the second thermosiphon 50 may be welded to the thermal connection point 58 on the lower portion of the first thermosiphon 48. Fig. 3 also diagrammatically depicts by arrows 64 a direction of the natural convection of the working fluid (e.g., helium) through the stainless steel piping or tubing or the like of the second thermosiphon 50. As further seen in Fig. 3, the thermosiphon 50 includes (or, viewed alternatively, is connected with) the pneumatic valve 52.

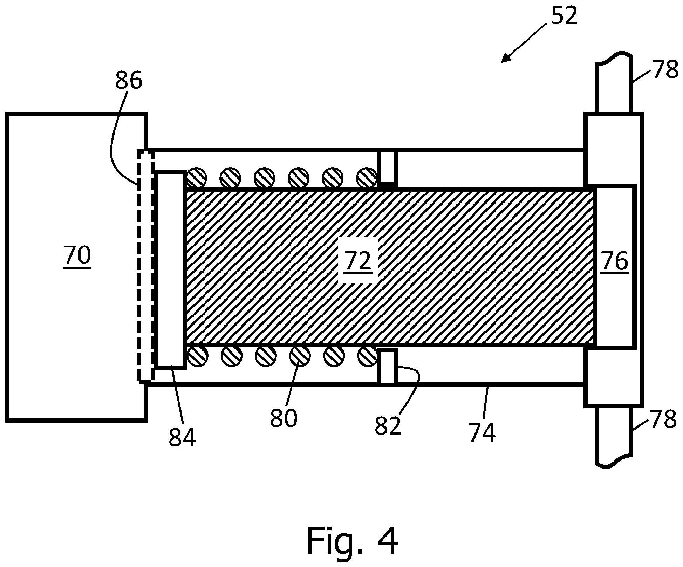

With continuing reference to Fig. 3 and with further reference to Fig. 4 which illustrates a sectional view of the pneumatic valve 52 of the second stage thermosiphon 50 of Fig. 3 according to a nonlimiting illustrative embodiment, the pneumatic valve 52 includes an expansion chamber 70 and a piston 72 disposed in a piston housing 74. The piston is arranged to engage into a valve seat 76, which may be connected with a portion of the tubing or piping of the thermosiphon 50 (e.g., by connections 78 illustrated in Fig. 4), or may be integrated into the tubing or piping of the thermosiphon 50. As shown only in the enlarged sectional view of Fig. 4, the illustrative pneumatic valve 52 further includes a spring 80 biasing the piston 72 into its open position that passes flow of the working fluid through the thermosiphon 50. Put another way, the spring 80 biases the piston 72 away from the valve seat 76, so that the pneumatic valve 52 is open. In the nonlimiting illustrative example of Fig. 4, a spring stop 82 is welded or otherwise disposed on the inner surface of the piston housing 74, and the spring 80 is compressed between a flange or flared end 84 of the piston 72 distal from the valve seat 76 and the spring stop 82. Furthermore, a diaphragm 86 operatively connects the expansion chamber 70 with the piston 72 so that expansion of a working fluid (e.g., helium or neon) contained in the expansion chamber 70 presses the diaphragm 86 against the flange or flared end 84 of the piston 72 to urge the piston 72 to move against the bias provided by the spring 80 to move the piston 72 into its closed position that blocks the flow of the working fluid through the thermosiphon 50. While a diaphragm 86 is illustrated, other types of operative connection of the expansion chamber 70 with the piston 72 are contemplated, such as a bellows.

With particular reference to Fig. 3, the expansion chamber 70 welded to a portion of the second thermosiphon 50 at or close to the lower portion 62 of the second thermosiphon 50 which is in thermal contact with the PCS 40. Other types of thermal connection between the expansion chamber 70 and the PCS 40 are also contemplated, such as a heat pipe (with or without a wick). Hence, the temperature of the expansion chamber 70 is at the same temperature as the PCS 40, or is at a temperature that is close to the temperature of the PCS 40. The pneumatic valve 52 is designed so that as long as the expansion chamber 70 is above a threshold temperature T1+, the expansion chamber 70 pushes the piston 72 against the spring biasing of the compressed spring 80 to move the piston 72 into (or maintain the piston 72 in) the closed position that blocks the flow of the working fluid through the thermosiphon 50. Due to its thermal contact with the lower portion 62 of the second thermosiphon 50 which is in thermal contact with the PCS 40, the temperature of the expansion chamber 70 at least approximately tracks the temperature of the PCS 40 as it cools due to action of the first thermosiphon 48. As the temperature of the expansion chamber 70 decreases, the working fluid therein densifies. When the temperature of the expansion chamber 70 decreases below the threshold temperature T1+, the working fluid has densified to an extent where the pressure in the expansion chamber 70 acting against the diaphragm 86 can no longer overcome the biasing force of the spring 80, so that the spring 80 opens the pneumatic valve 52 by moving the piston 72 out of the valve seat 76. As previously mentioned, the first thermosiphon 48 operates to cool the PCS 40 from its initial temperature when the heater 44 is turned off, down to about the temperature T1 of the first stage cold station 22 (e.g., around 40K in some embodiments); then, the second thermosiphon 50 operates to continue cooling the PCS 40 down to about the temperature T2 of the second stage cold station 24 (e.g., around 4K in some embodiments). Hence, it is contemplated for the threshold temperature T1+ to be equal to the temperature T1 of the first stage cold station 22, so that the second thermosiphon 50 is turned on by the opening of the pneumatic valve 52 at about the same time as the first thermosiphon 48 stops operating due to the decreasing temperature of the PCS 40 reaching the temperature T1 of the first stage cold station 22, thereby turning off natural convection in the first thermosiphon 48.

However, as also previously mentioned, there can advantageously be some overlapping temperature range during which both thermosiphons 48 and 50 are operating simultaneously. This ensures continuous cooling of the PCS 40 by natural convection as the falling temperature of the PCS 40 passes the temperature T1. To achieve this, the threshold temperature T1+ can optionally be designed to be slightly larger than the temperature T1 of the first stage cold station 22, that is, T1+>T1. In some nonlimiting embodiments in which temperature T1 of the first stage cold station 22 is about 40K, the threshold temperature T1+ may be about 50K, as a nonlimiting illustrative example. In general, the compression of the spring 80 and the design parameters of the expansion chamber 70 (such as its interior volume and the amount of working fluid contained therein) are chosen to design the pneumatic valve 52 to open at a design-basis threshold temperature T1+.

The components of the pneumatic valve 52 may comprise stainless steel, copper, copper alloy, or other materials. In one contemplated design, the expansion chamber 70 comprises copper or a copper alloy to provide good thermal connection with the PCS 40 while the remaining components (e.g., piston 72, piston housing 74, and spring 80) are made of stainless steel. These are merely some nonlimiting illustrative material examples.

The use of the pneumatic valve 52 advantageously provides a passive mechanism for turning the second thermosiphon 50 on at a desired temperature T1+ of the PCS 40, so that the second thermosiphon 50 does not present a low thermal resistance pathway from the PCS 40 to the second stage cold station 24 until the temperature of the PCS 40 is lowered enough so that it does not present a large thermal load that could lead to magnet quench. Use of the pneumatic valve 52 has substantial advantages for this purpose, such as not introducing electromagnetic fields within the superconducting magnet (as would be the case, for example, with a solenoid-actuated valve) and not requiring electrical feedthroughs passing through the vacuum vessel 10 to power an electrical valve actuator. Furthermore, there is no need for a temperature sensor to monitor the temperature of the PCS 40 as it cools down, since the pneumatic valve 52 is advantageously designed to automatically open when the temperature of the PCS 40 drops enough for the thermally connected expansion chamber 70 to cool below the threshold temperature T1+.

With reference now to Fig. 5, another embodiment is illustrated of the second stage thermosiphon 50 connecting the PCS 40 and the second stage cold station 24 of the cryogenic cold head 20. The second stage thermosiphon 50 of the embodiment of Fig. 5 has some similarities with the second stage thermosiphon 50 of the embodiment of Fig. 3, and includes the upper portion 60 of the second thermosiphon 50 comprising a plate, paddle, surface, or other structure shaped and/or otherwise configured to be welded or otherwise thermally connected with the second stage cold station 24, and the lower portion 62 of the second thermosiphon 50 comprising a plate, paddle, surface, or other structure shaped and/or otherwise configured to be welded or otherwise thermally connected with the PCS 40. Fig. 5 also diagrammatically depicts by arrows 64 the direction of the natural convection of the working fluid (e.g., helium) through the stainless steel piping or tubing or the like of the second thermosiphon 50.

The embodiment of Fig. 5 omits the pneumatic valve 52 of the embodiment of Fig. 3. In its place, the embodiment of Fig. 5 includes one or more heaters 90, 92 arranged to heat the upper portion 60 of the second thermosiphon 50 to a temperature higher than the temperature of the PCS 40 with its heater 44 operating. Thus, when the heaters 90, 92 are on the upper portion 60 of the second thermosiphon 50 is hotter than the lower portion 62 of the second thermosiphon 50, thereby ensuring that the natural convection 64 does not circulate. The heaters 90, 92 are kept on until the temperature of the PCS 40 drops low enough (e.g., close to the temperature T1 of the first stage cold station 22) so that the heaters 90, 92 can be turned off to initiate the natural convection 64 to further cool the PCS 40 without risking magnet quench. To implement this approach, electrical feedthroughs (not shown) passing through the vacuum vessel 10 would deliver electrical power the (e.g., resistive) heaters 90, 92.

The embodiment of the second thermosiphon 50 shown in Fig. 5 further includes the liquid drop 54 previously mentioned with reference to Fig. 1. When the second thermosiphon 50 is cool enough, the liquid drop 54 contains at least a portion of the working fluid of the thermosiphon 50 in liquid phase. A heater 100 is arranged to heat the liquid drop of the thermosiphon to boil working fluid contained in the liquid drop 54. When the thermosiphon 50 is not operating (i.e., natural convection 64 is not flowing due to operation of the heaters 90, 92) the liquid drop 54 is cool and some of the working fluid can condense in the liquid drop 54 in the liquid phase (e.g., as liquid helium if the working fluid is helium). When the heaters 90, 92 are turned off to start the natural convection 64, the heater 100 is also turned on. This heats the liquid drop 54 to rapidly boil off the liquid helium (or other liquid phase working fluid) and accelerate the operation of the thermosiphon 50 by boiling working fluid of the thermosiphon 50 contained in a liquid drop 54.

Thus, the liquid drop 54 stores liquid helium during ramping of the magnet current. After the ramp the heater 100 is turned on, thus rapidly boiling the liquid helium. The boiled helium is now vapor, but is still much colder than the PCS 40. The helium will boil off around 5K and after ramp the MCPS is around 80K in some nonlimiting illustrative examples. As this liquid turns to vapor it quickly expands into the rest of the loop of the thermosiphon 50 which cools the PCS 40. With a sufficient volume of the liquid drop 54, this can cool the PCS 40 down very quickly.

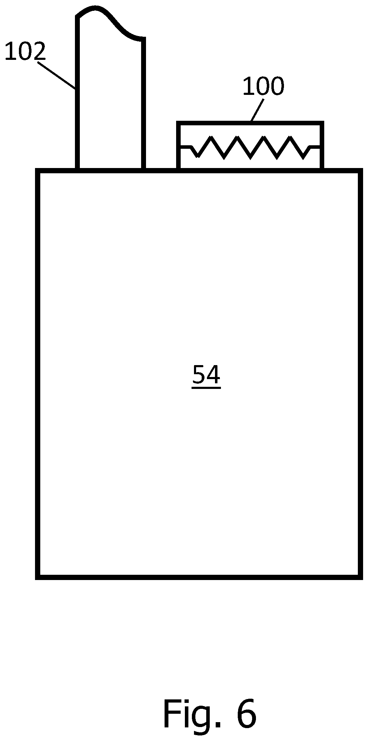

With reference to Fig. 6, the liquid drop 54 can be designed to have a chosen volume and geometry. The variant example of Fig. 6 shows an example of a cylindrical or rectangular liquid drop 54 connected with the thermosiphon 50 (not shown in Fig. 6) by an inlet 102. In the example of Fig. 6, the heater 100 is disposed on an upper surface of the liquid drop 54, but it could instead be located on the side or could extend around the perimeter of the liquid drop or be otherwise located.

While Fig. 5 shows the liquid drop 54 being employed in conjunction with using the heaters 90, 92 to initiate the natural convection 64 in the thermosiphon 50, it is alternatively contemplated to employ the liquid drop 54 in combination with using the pneumatic valve 52 of Fig. 3 to initiate the natural convection 64 in the thermosiphon 50.

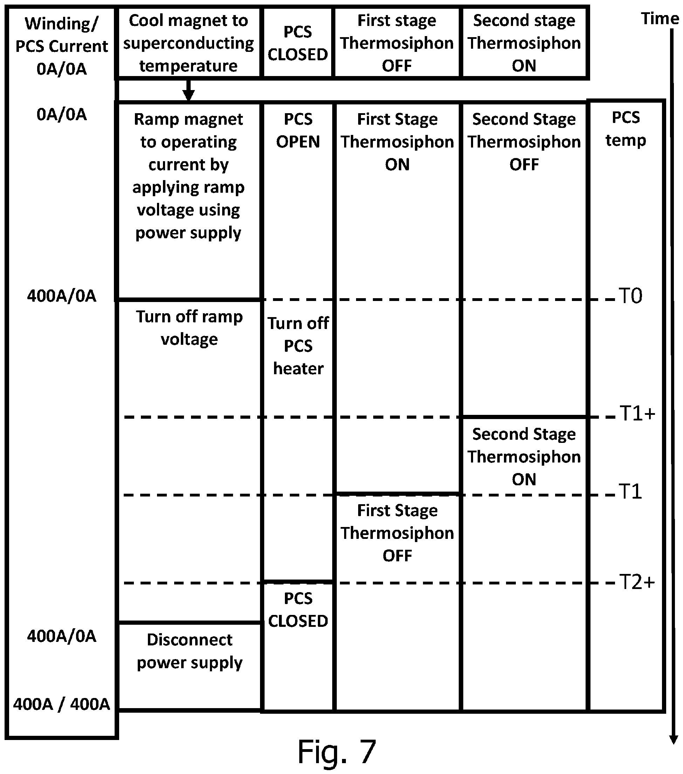

With reference to Fig. 7, a ramp sequence is diagrammatically shown. The vertical axis corresponds to time, and columns from left to right indicate the electric current in the superconducting windings 12, operation of the electrical ramping, setting of the PCS 40, and the status of the first thermosiphon 48 and the second thermosiphon 50. Initially, the magnet is cooled by operation of the cryogenic cold head 20. Then, the PCS 40 is opened by turning on the PCS heater 44, and the magnet ramp is initiated by applying a ramp voltage using the power supply 30. At this stage, the first thermosiphon 48 is on (i.e., natural convection is flowing) since the PCS 40 is being heated and so the lower portion of the first thermosiphon 48 is hotter than the upper portion of the first thermosiphon 48 which is at about the temperature T1 of the first stage cold station 22. The second thermosiphon 50 is off (i.e., natural convection is not flowing) because the heated PCS 40 also heats the expansion chamber 70 of the pneumatic valve 52 to keep the pneumatic valve 52 closed. In Fig. 7, the temperature of the PCS 40 being heated by the PCS heater 44 is indicated as a temperature T0, which in one nonlimiting illustrative example is about 80K.

In the nonlimiting example of Fig. 7, the magnet windings 12 are ramped up to an operating current of 400A. At this point, the ramp voltage being applied by the power supply 30 is turned off, and the PCS heater 44 is also turned off. At this point, the PCS 40 is still at the temperature T0 (e.g., 80K), but will start to cool radiatively and also assisted by the natural convection flowing through the first thermosiphon 48. The second thermosiphon 50 remains off until the temperature of the PCS 40 (and hence of the expansion chamber 70 of the pneumatic valve 52) falls below the threshold temperature T1+, at which point the pneumatic valve 52 opens to initiate natural convection 64, thereby turning the second thermosiphon 50 on. During the time interval over which the PCS 40 further cools from T1+ to T1, both the first thermosiphon 48 and the second thermosiphon 50 are no and providing cooling of the PCS 40 by natural convection in the respective thermosiphons. However, when the temperature of the PCS 40 decreases below the temperature T1 of the first stage cold station 22, the first thermosiphon 48 turns off because there is no longer the requisite temperature differential to drive natural convection in the first thermosiphon 48. The second thermosiphon 50 continues to operate to cool the PCS 40. When the temperature of the PCS 40 decreases below the superconducting transition temperature of the superconductor 42 of the PCS 40, the PCS closes (i.e., the superconductor 42 becomes superconducting to present zero resistance between the leads 34 of the superconducting magnet windings 12), thus placing the magnet into persist (i.e., persistence) mode. At this point, the power supply 30 can be disconnected.

The present disclosure, through one or more of its various aspects, embodiments and/or specific features or sub-components, is thus intended to bring out one or more of the advantages as specifically noted below. For purposes of explanation and not limitation, example embodiments disclosing specific details are set forth in order to provide a thorough understanding of an embodiment according to the present teachings. However, other embodiments consistent with the present disclosure that depart from specific details disclosed herein remain within the scope of the appended claims. Moreover, descriptions of well-known apparatuses and methods may be omitted so as to not obscure the description of the example embodiments. Such methods and apparatuses are within the scope of the present disclosure.

## Claims

1. A superconducting magnet for a magnetic resonance imaging (MRI) device, the superconducting magnet comprising:
a vacuum vessel (10);
superconducting magnet windings (12) disposed in the vacuum vessel;
a persistent current switch (PCS) (40) comprising a superconductor (42) connecting with the superconducting magnet windings and a heater (44), the PCS operative to switch between a persist mode in which the heater is off and a ramp mode in which the heater is on;
a cryogenic cold head (20) having a cold station (24) thermally connected with the superconducting magnet windings to cool the superconducting magnet windings;
a thermosiphon (50) thermally connecting the cold station of the cryogenic cold head with the PCS, the thermosiphon containing a working fluid; and
a pneumatic valve (52) having an expansion chamber (70), the pneumatic valve configured to block flow of the working fluid through the thermosiphon when the expansion chamber is above a threshold temperature (T1+) and to pass flow of the working fluid through the thermosiphon when the expansion chamber is below the threshold temperature.

2. The superconducting magnet of claim 1, wherein the expansion chamber (70) of the pneumatic valve (52) is thermally connected with the PCS (40).

3. The superconducting magnet of any one of claims 1-2, wherein the pneumatic valve (52) further comprises:
a piston (72) disposed in a piston housing (74); and
a spring (80) biasing the piston into an open position that passes flow of the working fluid through the thermosiphon (50);
wherein the expansion chamber (70) above the threshold temperature (T1+) presses against the spring biasing to move the piston into a closed position that blocks the flow of the working fluid through the thermosiphon.

4. The superconducting magnet of any one of claims 1-3, wherein the cryogenic cold head (20) has a first stage cold station (22) and a second stage cold station (24), the cryogenic cold head being configured to cool the first stage cold station to a first stage temperature (T1) and to cool the second stage cold station to a second stage temperature (T2) that is lower than the first stage temperature, the thermosiphon (50) thermally connecting the cold station of the cryogenic cold head with the PCS being a second thermosiphon (50) thermally connecting the second stage cold station (24) of the cryogenic cold head with the PCS (40), and the superconducting magnet further comprises:
a first thermosiphon (48) thermally connecting the first stage cold station (22) of the cryogenic cold head with the PCS.

5. The superconducting magnet of claim 4, wherein the threshold temperature (T1+) is higher than the first stage temperature (T1).

6. The superconducting magnet of any one of claims 1-5, wherein the thermosiphon (50) includes a liquid drop (54).

7. The superconducting magnet of claim 6, further comprising:
a heater (100) arranged to heat the liquid drop (54) of the thermosiphon (50) to boil working fluid contained in the liquid drop.

8. The superconducting magnet of any one of claims 6-7, further comprising:
at least one heater (90, 92) configured to be switched on to heat an upper portion (60) of the thermosiphon (50) to prevent operation of the thermosiphon and to be switched off to allow operation of the thermosiphon.

9. The superconducting magnet of any one of claims 1-8, wherein the working fluid is helium.

10. The superconducting magnet of any one of claims 1-9, wherein the superconducting magnet is configured to operate with no liquid helium charge inside the vacuum vessel (10) or with a liquid helium charge of less than or equal to 10 liters inside the vacuum vessel.

11. A superconducting magnet for a magnetic resonance imaging (MRI) device, the superconducting magnet comprising:
a vacuum vessel (10);
superconducting magnet windings (12) disposed in the vacuum vessel;
a persistent current switch (PCS) (40) comprising a superconductor (42) connecting with the superconducting magnet windings and a heater (44), the PCS operative to switch between a persist mode in which the heater is off and a ramp mode in which the heater is on;
a cryogenic cold head (20) having a cold station (24) thermally connected with the superconducting magnet windings to cool the superconducting magnet windings; and
a thermosiphon (50) thermally connecting the cold station of the cryogenic cold head with the PCS, the thermosiphon containing a working fluid;
wherein the thermosiphon (50) includes a liquid drop (54).

12. The superconducting magnet of claim 11, further comprising:
a pneumatic valve (52) configured to control operation of the thermosiphon (50).

13. The superconducting magnet of any one of claims 11-12, further comprising a heater (100) arranged to heat the liquid drop (54) of the thermosiphon (50) to boil working fluid contained in the liquid drop.

14. The superconducting magnet of any one of claims 11-13, further comprising:
at least one heater (90, 92) configured to be switched on to heat an upper portion (60) of the thermosiphon (50) to prevent operation of the thermosiphon and to be switched off to allow operation of the thermosiphon.

15. The superconducting magnet of any one of claims 11-14, wherein the cryogenic cold head (20) has a first stage cold station (22) and a second stage cold station (24), the cryogenic cold head being configured to cool the first stage cold station to a first stage temperature (T1) and to cool the second stage cold station to a second stage temperature (T2) that is lower than the first stage temperature, the thermosiphon (50) thermally connecting the cold station of the cryogenic cold head with the PCS being a second thermosiphon (50) thermally connecting the second stage cold station (24) of the cryogenic cold head with the PCS, and the superconducting magnet further comprises:
a first thermosiphon (48) thermally connecting the first stage cold station (22) of the cryogenic cold head with the PCS (40).
